# EUROPEAN PATENT SPECIFICATION

(11) **EP 2 348 531 B1**
(45) Date of publication and mention of the grant of the patent: **26.05.2021**
(21) Application number: 11152094.6
(22) Date of filing: 25.01.2011
(51) Int. Cl.: H01L 29/786, H01L 29/417

(54) **THIN FILM TRANSISTOR AND METHOD OF MANUFACTURING THE SAME**
DÜNNFILMTRANSISTOR UND HERSTELLUNGSVERFAHREN DAFÜR
TRANSISTOR À COUCHE MINCE ET SON PROCÉDÉ DE FABRICATION

(30) Priority: 26.01.2010 KR 20100007078; 17.01.2011 KR 20110004535
(43) Date of publication of application: 27.07.2011
(73) Proprietor: Samsung Electronics Co., Ltd., Suwon-si, Gyeonggi-do, 443-742 (KR)
(72) Inventor: KIM, Eok-su, 449-712 Gyeonggi-do (KR); LEE, Sang-yoon, 449-712 Gyeonggi-do (KR); RYU, Myung-kwan, 449-712 Gyeonggi-do (KR); PARK, Kyung-bae, 449-712 Gyeonggi-do (KR)
(74) Representative: Elkington and Fife LLP

(56) References cited:
- EP-A1- 2 445 011
- EP-A2- 2 086 011
- US-A1- 2004 046 164
- US-A1- 2005 196 711
- US-A1- 2008 135 846
- US-A1- 2009 218 605

## Description

### BACKGROUND

### 1. Field

The present disclosure relates to thin film transistors (TFTs) and methods of manufacturing the same.

### 2. Description of the Related Art

Thin film transistors (TFTs) are used in various fields, and particularly, used as switching and driving devices in display devices and as select switches in cross-point memory devices.

Amorphous silicon (a-Si) TFTs are used as driving and switching devices in display devices. A-Si TFTs which may be uniformly formed on a large substrate with a size greater than 2 m at low cost are the most widely used TFTs. However, as display devices get larger and have higher equality, TFTs are required to have higher performance. However, there is a limitation in using existing a-Si TFTs having a mobility of about 0.5 cm²/Vs. Also, in general, since a-Si TFTs undergo processes at a high temperature of about 300°C, it is difficult to apply a-Si TFTs to polymer substrates or the like for manufacturing flexible display devices.

Accordingly, various TFTs which may replace a-Si TFTs have been developed.

Since polycrystalline silicon thin film transistors (poly-Si TFTs) have a high mobility of tens to hundreds of cm²/Vs, poly-Si TFTs may be applied to high quality display devices to which it is difficult to apply existing a-Si TFTs. Also, poly-Si TFTs suffer less characteristic degradation than a-Si TFTs. However, it is difficult to make poly-Si TFTs larger because of a limitation of manufacturing equipment or a technical problem such as poor uniformity.

It is easy to make oxide semiconductor TFTs larger because an oxide semiconductor is amorphous. Since oxide semiconductor TFTs have a higher mobility than a-Si TFTs, oxide semiconductor TFTs are spotlighted as the next generation TFTs that may replace a-Si TFTs. However, electrical characteristics of oxide semiconductor TFTs may be changed by an external impact such as damage or moisture or oxygen adsorption.

When compared with existing silicon TFTs, organic TFTs (OTFTs) may be manufactured at low cost because a semiconductor layer may be formed by a wet process, not by plasma-enhanced chemical vapour deposition (PECVD), and the overall OTFTs may be manufactured by using a roll-to-roll process using a plastic substrate if necessary. However, OTFTs have a lower charge mobility and a higher leakage current than silicon TFTs.

US2008/0135846 describes a TFT protection transistor with multiple floating electrodes to allow the width/length ratio of the channel to be adjusted to arrive at suitable properties.

### SUMMARY

Provided are thin film transistors (TFTs) and methods of manufacturing the same.

Additional aspects will be set forth in part in the description which follows and, in part, will be apparent from the description, or may be learned by practice of the presented embodiments.

The present invention is defined in the claims.

### BRIEF DESCRIPTION OF THE DRAWINGS

These and/or other aspects will become apparent and more readily appreciated from the following description of the embodiments, taken in conjunction with the accompanying drawings of which:
FIG. 1 is a cross-sectional view illustrating an oxide thin film transistor (TFT) having a floating channel;
FIGS. 2A through 2E are cross-sectional views illustrating a method of manufacturing the oxide TFT of FIG. 1; and
FIG. 3 is a cross-sectional view illustrating an oxide TFT according to an embodiment of the present invention.

### DETAILED DESCRIPTION

The present invention will now be described more fully with reference to the accompanying drawings, in which exemplary embodiments of the invention are shown. In the drawings, the same reference numerals denote the same elements, and sizes or thicknesses of elements may be exaggerated for clarity.

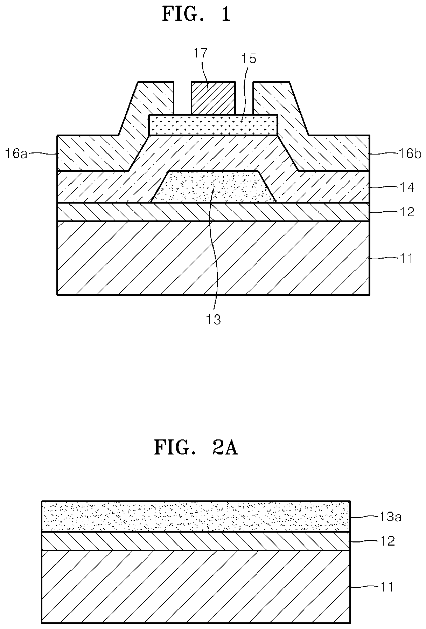

FIG. 1 is a cross-sectional view illustrating an oxide thin film transistor (TFT). Although the oxide TFT is a bottom gate TFT in FIG. 1, the oxide TFT may be any of a top gate TFT and a bottom gate TFT.

Referring to FIG. 1, the oxide TFT may include a gate 13 partially formed on a substrate 11, and a gate insulating layer 14 formed on the substrate 11 and the gate 13. If the substrate 11 is formed of silicon (Si), an oxide layer 12 may be further formed on a surface of the substrate 11 by using thermal oxidation. A channel 15 may be formed on the gate insulating layer 14 to correspond to the gate 13, and a source 16a and a drain 16b may be formed on the gate insulating layer 14 and on both side portions of the channel 15. A floating channel 17 may be formed on a surface of the channel 15 to be spaced apart from the source 16a and the drain 16b.

The substrate 11 may be a substrate used in a general semiconductor device, and may be formed of, for example, silicon, glass, or an organic material. The oxide layer 12 formed on the surface of the substrate 11, which is formed by performing thermal oxidation on the substrate 11 formed of silicon, may be formed of SiO₂.

The gate 13 may be formed by using a conductive material, for example, a metal such as titanium (Ti), platinum (Pt), ruthenium (Ru), gold (Au), silver (Ag), molybdenum (Mo), aluminum (Al), tungsten (W), or copper (Cu), or a conductive oxide such as InZnO (IZO) or AlZnO (AZO). The gate insulating layer 14 may be formed of an insulating material used in a typical semiconductor device. In detail, the gate insulating layer 14 may be formed of HfO₂, Al₂O₃, Si₃N₄, or a combination thereof which is a high-K material having a higher dielectric constant than SiO₂.

The channel 15 may be formed of a general semiconductor material, for example, an oxide semiconductor, an organic semiconductor, any of III-V semiconductors such as C, Si, Ge, SiGe, GaN, GaAs, InSb, InP, and CdS or a compound thereof, carbon nanotubes, or graphene.

The source 16a and the drain 16b may be formed of a conductive material, for example, a metal such as Ti, Pt, Ru, Au, Ag, Mo, Al, W, or Cu or a conductive oxide such as InZnO (IZO) or AlZnO (AZO).

The floating channel 17 may be formed of a general conductive material, and may be formed of the same material as that of the source 16a and the drain 16b. For example, the floating channel 17 may be formed of a metal, an alloy, a metal oxide such as indium tin oxide (ITO) or indium zinc oxide (IZO), an intermetallic compound, a conductive polymer, an impurity-doped semiconductor, carbon nanotubes, or graphene. While both side portions of the channel 15 are in contact with the source 16a and the drain 16b, both side portions of the floating channel 17 are spaced apart from the source 16a and the drain 16b. Accordingly, it is unnecessary to separately adjust an off state of the floating channel 17.

A resistance of the floating channel 17 is lower than a resistance of the channel 15 when the channel 15 is turned on. In this case, since carriers mostly move through the floating channel 17 having a lower resistance, the oxide TFT may be more efficient than the oxide TFT uses only the channel 15. For example, if a channel is formed of an oxide, because of characteristics of an oxide semiconductor, an electric field between a source and a drain increases as a length of the channel decreases, and thus a threshold voltage Vth of a TFT is shifted to a negative value, thereby exceeding a general TFT driving range. In order to prevent this problem, the length of the channel of the TFT should be increased. However, if the length of the channel is increased, an ON current 'Ion' of the TFT is reduced. However, if the floating channel 17 having a resistance lower than that of the channel 15 when the channel 15 is turned on is formed as shown in the present embodiment, since the resistance of the floating channel 17 is low, a current is not reduced even though a length of the oxide TFT is increased. Accordingly, a positive threshold value may be obtained by increasing or maintaining a length of the channel 15 of the oxide TFT, and also a high current and a high mobility may be obtained by reducing a length of an effective channel. For reference, a length of a channel refers to a distance between the source 16a and the drain 16b.

Also, if the channel is formed of an organic material, an organic semiconductor layer may be formed by using a general printing process. In this case, due to a resolution limit of the printing process, the length of the channel may not be reduced, thereby reducing an ON current 'Ion' of the TFT. However, if the floating channel 17 is formed as shown in the present embodiment, since the resistance of the floating channel 17 is low, a current is not reduced even though the length of the channel 15 of the oxide TFT is increased, and also a high current may be obtained.

A method of manufacturing the oxide TFT of FIG. 1 will be explained with reference to FIGS. 2A through 2E.

Referring to FIG. 2A, the substrate 11 is prepared. The substrate 11 may be mainly formed of silicon, glass, or plastic, but the present embodiment is not limited thereto. If the substrate 11 is formed of silicon, the insulating layer 12 formed of, for example, SiO₂, may be formed on a surface of the substrate 11 by using thermal oxidation. A conductive material 13a such as a metal or a conductive metal oxide is applied to the substrate 11.

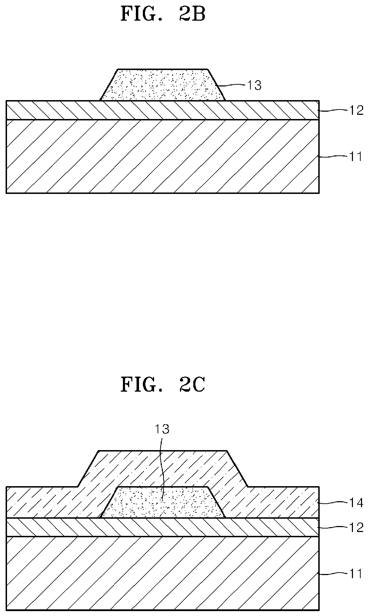

Referring to FIG. 2B, the gate 13 is formed by patterning the conductive material 13a. Referring to FIG. 2C, the gate insulating layer 14 is formed by applying and patterning an insulating material on the gate 13. The gate insulating layer 14 may be formed of a silicon oxide, a silicon nitride, a hafnium (Hf) oxide, an aluminum oxide, or a mixture of a hafnium oxide and an aluminum oxide.

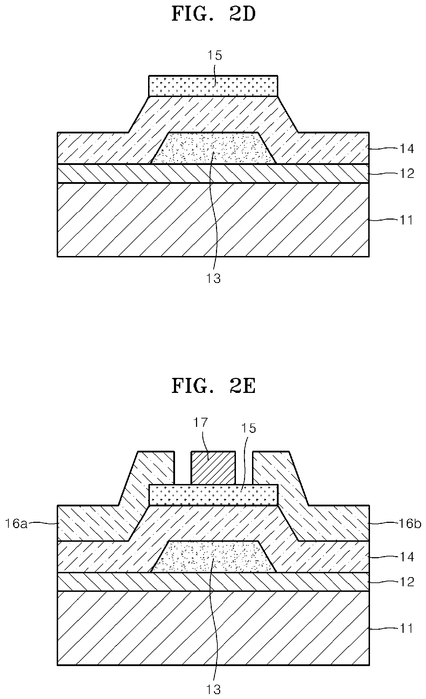

Referring to FIG. 2D, the channel 15 is formed by patterning a channel material on the gate insulating layer 14. The channel 15 may be formed by applying the channel material by using physical vapor deposition (PVD), chemical vapor deposition (CVD), or atomic layer deposition (ALD) and performing patterning to remain the channel material on the gate insulating layer 14 to correspond to the gate 13, or may be directly formed on a corresponding position by using printing or the like.

Referring to FIG. 2E, the source 16a, the drain 16b, and the floating channel 17 are formed by applying and patterning a material, such as a metal or a conductive metal oxide, on the channel 15 and the gate insulating layer 14.

Finally, the oxide TFT may be completed by performing heat treatment by using a general furnace, rapid thermal annealing (RTA), laser, or hot plate, at a temperature less than 400°C, for example, about 300°C.

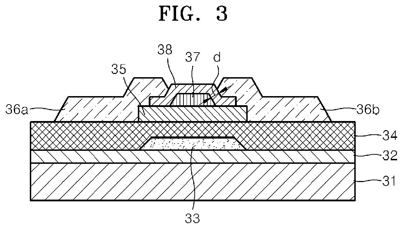

FIG. 3 is a cross-sectional view illustrating an oxide TFT according to an embodiment of the present invention.

Referring to FIG. 3, a gate 33 is partially formed on a substrate 31, and a gate insulating layer 34 is formed on the substrate 31 and the gate 33. If the substrate 31 is formed of silicon, a silicon oxide layer 32 may be further formed on a surface of the substrate 31 by using thermal oxidation. A channel 35 is partially formed on the gate insulating layer 34, for example, may be formed on the gate insulating layer 34 to correspond to the gate 33, and a source 36a and a drain 36b are formed on both side portions of the channel 35. A floating channel 37 is be further formed on a surface of the channel 35. The floating channel 37 has a smaller width than that of the channel 35, and is spaced apart by a predetermined distance 'd' from the source 36a and the drain 36b.

The distance 'd' between the floating channel 37 and the source 36a or between the floating channel 37 and the drain 36b may be adjusted to be several to several hundreds of nanometers. In particular, an insulating layer 38 is further formed on the floating channel 37 in order to achieve a shorter distance. At least one of the source 36a and the drain 36b is formed to contact end portions of the channel 35 and the insulating layer 38. As shown in FIG. 3, the distance 'd' between the floating channel 37 and the source 36a or the drain 36b is substantially equal to a thickness of the insulating layer 38.

A distance between the floating channel 37 and the source 36a or the drain 36b may be controlled by forming the insulating layer 38 to a thickness of several to several hundreds of nanometers. Since a length of the channel 35 of FIG. 3 is shorter than a length of the channel 15 of FIG. 1, an ON current and a channel mobility may be improved.

The substrate 31, the oxide layer 32, the gate 33, the gate insulating layer 34, the channel 35, the source 36a, the drain 36b, and the floating channel 37 illustrated in FIG. 3 may be formed of the same materials as their counterparts in FIG. 1. The insulating layer 38 may be formed of an insulating material used in a general semiconductor device, for example, a silicon oxide, a silicon nitride, a high-K material, or a mixture thereof.

The method of FIGS. 2A through 2D may apply to a method of manufacturing the oxide TFT of FIG. 3. After the channel 35 is formed, the floating channel 37 is first formed by applying and patterning a material, such as a metal or a conductive metal oxide, on the channel 37. The insulating layer 38 is formed by applying an insulating material with a thickness of several to several hundreds of nanometers to the floating channel 37 to surround the floating channel 37. The source 36a and the drain 36b may be formed by applying and patterning a material, such as a metal or a conductive metal oxide, on the gate insulating layer 34, the channel 35, and the insulating layer 38.

According to the one or more embodiments of the present invention, an oxide TFT with a high mobility which may obtain a positive threshold value by increasing or maintaining a length of an entire channel of a TFT, and may also obtain a high current by reducing a length of an effective channel may be provided.

Various electronic devices such as a driving transistor of a flat panel display device such as a liquid crystal display (LCD) or an organic light-emitting diode (OLED), and a transistor for a peripheral circuit of a memory device would have been easily manufactured by one of ordinary skill in the art by using the aforesaid embodiments. The oxide TFT according to the one or more embodiments of the present invention may be a bottom gate TFT or a top gate TFT. Accordingly, the scope of the present invention is not defined by the above-described embodiments but defined by the appended claims.

## Claims

1. A thin film transistor, TFT, comprising:
a source (36a) and a drain (36b);
a channel (35) formed between the source and the drain;
a gate (33) formed on a substrate to correspond to the channel (35).
a gate insulating layer (34) formed between the gate (33) and the channel (35);
a floating channel (37) electrically connected and in contact with the channel (35), the floating channel (37) being over the channel (35) and spaced apart from the source (36a) and the drain (36b) so that it does not contact the source and drain, and wherein the resistance of the floating channel is less than a resistance of the channel when the channel is turned on; and an insulating layer (38) formed on the floating channel,
and **characterised in that** at least one of the source (36a) and the drain (36b) contacts end portions of the channel (35) and the insulating layer (38),
and **in that** a distance between the floating channel (37) and the source (36a) and/or between the floating channel (37) and the drain (36b) is equal to a thickness of the insulating layer.

2. The TFT of any preceding claim, wherein the channel (35) comprises an oxide.

3. The TFT of any preceding claim, wherein the floating channel (37) is formed of a material selected from the group consisting of a metal, a metal alloy, a metal oxide, an intermetallic compound, a conductive polymer, an impurity-doped semiconductor, carbon nanotubes, and graphene, or a combination thereof.

4. A method of manufacturing a TFT, the method comprising:
forming a gate (33) and a gate insulating layer (34) on a substrate (31);
forming a channel (35) on the gate insulating layer;
forming a conductive layer to cover the gate insulating layer and the channel;
forming a floating channel (35) in contact with and electrically connected to the channel (35), the floating channel (35) being over the channel (35), and wherein the resistance of the floating channel is less than a resistance of the channel when the channel is turned on;
forming an insulating layer (38) on the channel (35) and the floating channel; and
forming a source (36a) and a drain on: the gate insulating layer; the channel (35); and the insulating layer (38), wherein the source (36a) and drain (36b) contact end portions of the channel (35) and the insulating layer (38); wherein the floating channel (35) is spaced apart from the source (36a) and the drain (36b) so that it does not contact the source and the drain; and wherein the insulating layer (38) is formed between the floating channel (37) and the source (36a) and the drain (36b),
and a distance between the floating channel (37) and the source (36a) and/or between the floating channel (37) and the drain (36b) is equal to a thickness of the insulating layer (36b).

## Patentansprüche

1. Dünnfilmtransistor, TFT, umfassend:
eine Quelle (36a) und einen Abfluss (36b);
einen Kanal (35), der zwischen der Quelle und dem Abfluss ausgebildet ist;
ein Gate (33), das auf einem Substrat ausgebildet ist, um dem Kanal (35) zu entsprechen;
eine Gate-Isolierschicht (34), die zwischen dem Gate (33) und dem Kanal (35) ausgebildet ist;
einen schwimmenden Kanal (37), der mit dem Kanal (35) elektrisch verbunden ist und in Kontakt steht, wobei der schwimmende Kanal (37) über dem Kanal (35) liegt und von der Quelle (36a) und dem Abfluss (36b) beabstandet ist, sodass er die Quelle und den Abfluss nicht kontaktiert, und wobei der Widerstand des schwimmenden Kanals geringer als ein Widerstand des Kanals ist, wenn der Kanal eingeschaltet ist; und eine Isolierschicht (38), die auf dem schwimmenden Kanal ausgebildet ist,
und **dadurch gekennzeichnet, dass** zumindest eines von der Quelle (36a) und dem Abfluss (36b) Endabschnitte des Kanals (35) und der Isolierschicht (38) kontaktiert,
und dass ein Abstand zwischen dem schwimmenden Kanal (37) und der Quelle (36a) und/oder zwischen dem schwimmenden Kanal (37) und dem Abfluss (36b) gleich einer Dicke der Isolierschicht ist.

2. TFT nach einem vorhergehenden Anspruch, wobei der Kanal (35) ein Oxid umfasst.

3. TFT nach einem vorhergehenden Anspruch, wobei der schwimmende Kanal (37) aus einem Material gebildet ist, das aus der Gruppe ausgewählt ist, die aus einem Metall, einer Metalllegierung, einem Metalloxid, einer intermetallischen Verbindung, einem leitfähigen Polymer, einem verunreinigungsdotierten Halbleiter, Kohlenstoffnanoröhren und Graphen oder einer Kombination davon besteht.

4. Verfahren zur Herstellung eines TFT, wobei das Verfahren Folgendes umfasst:
Ausbilden eines Gates (33) und einer Gate-Isolierschicht (34) auf einem Substrat (31);
Ausbilden eines Kanals (35) auf der Gate-Isolierschicht;
Ausbilden einer leitfähigen Schicht zum Abdecken der Gate-Isolierschicht und des Kanals;
Ausbilden eines schwimmenden Kanals (35), der mit dem Kanal (35) in Kontakt und elektrisch damit verbunden ist, wobei der schwimmende Kanal (35) über dem Kanal (35) liegt,
und wobei der Widerstand des schwimmenden Kanals geringer als ein Widerstand des Kanals ist, wenn der Kanal eingeschaltet ist;
Ausbilden einer Isolierschicht (38) auf dem Kanal (35) und dem schwimmenden Kanal; und
Ausbilden einer Quelle (36a) und eines Abflusses auf: der Gate-Isolierschicht; dem Kanal (35); und der Isolierschicht (38), wobei die Quelle (36a) und der Abfluss (36b) Endabschnitte des Kanals (35) und der Isolierschicht (38) kontaktieren; wobei der schwimmende Kanal (35) von der Quelle (36a) und dem Abfluss (36b) beabstandet ist, sodass er die Quelle und den Abfluss nicht kontaktiert; und wobei die Isolierschicht (38) zwischen dem schwimmenden Kanal (37) und der Quelle (36a) und dem Abfluss (36b) gebildet ist,
und ein Abstand zwischen dem schwimmenden Kanal (37) und der Quelle (36a) und/oder zwischen dem schwimmenden Kanal (37) und dem Abfluss (36b) gleich einer Dicke der Isolierschicht (36b) ist.

## Revendications

1. Transistor à couches minces, TFT, comprenant :
une source (36a) et un drain (36b) ;
un canal (35) formé entre la source et le drain ;
une grille (33) formée sur un substrat pour correspondre au canal (35),
une couche isolante de grille (34) formée entre la grille (33) et le canal (35) ;
un canal flottant (37) raccordé électriquement et en contact avec le canal (35), le canal flottant (37) étant sur le canal (35) et espacé de la source (36a) et du drain (36b) afin qu'il ne soit pas en contact avec la source et le drain, et ladite résistance du canal flottant étant inférieure à une résistance du canal lorsque le canal est activé ; et une couche isolante (38) formée sur le canal flottant,
et **caractérisé en ce qu'**au moins l'un de la source (36a) et du drain (36b) est en contact avec des parties d'extrémité du canal (35) et de la couche isolante (38),
et **en ce qu'**une distance entre le canal flottant (37) et la source (36a) et/ou entre le canal flottant (37) et le drain (36b) est égale à une épaisseur de la couche isolante.

2. TFT selon une quelconque revendication précédente, ledit canal (35) comprenant un oxyde.

3. TFT selon une quelconque revendication précédente, ledit canal flottant (37) étant formé d'un matériau choisi dans le groupe constitué par un métal, un alliage métallique, un oxyde métallique, un composé intermétallique, un polymère conducteur, un semi-conducteur dopé aux impuretés, des nanotubes de carbone et du graphène, ou une combinaison de ceux-ci.

4. Procédé de fabrication d'un TFT, le procédé comprenant :
la formation d'une grille (33) et d'une couche isolante de grille (34) sur un substrat (31) ;
la formation d'un canal (35) sur la couche isolante de grille ;
la formation d'une couche conductrice pour recouvrir la couche isolante de grille et le canal ;
la formation d'un canal flottant (35) en contact avec le canal (35) et raccordé électriquement à celui-ci, ledit canal flottant (35) étant au-dessus du canal (35),
et ladite résistance du canal flottant étant inférieure à une résistance du canal lorsque le canal est activé ;
la formation d'une couche isolante (38) sur le canal (35) et le canal flottant ; et
la formation d'une source (36a) et d'un drain sur : la couche isolante de grille ; le canal (35) ; et la couche isolante (38), ladite source (36a) et ledit drain (36b) étant en contact avec les parties d'extrémité du canal (35) et de la couche isolante (38) ; ledit canal flottant (35) étant espacé de la source (36a) et du drain (36b) afin qu'il ne soit pas en contact avec la source et le drain ; et ladite couche isolante (38) étant formée entre le canal flottant (37) et la source (36a) et le drain (36b),
et une distance entre le canal flottant (37) et la source (36a) et/ou entre le canal flottant (37) et le drain (36b) étant égale à une épaisseur de la couche isolante (36b).
